Europäisches Patentamt

European Patent Office

Office européen des brevets

(11) Veröffentlichungsnummer: **0 271 682 B1**

(12) # EUROPÄISCHE PATENTSCHRIFT

(45) Veröffentlichungstag der Patentschrift:
01.08.90

(51) Int. Cl.⁵: **C23C 14/30, H01J 37/305**

(21) Anmeldenummer: 87115863.0

(22) Anmeldetag: 29.10.87

(54) Verdampferanordnung mit einem rechteckigen Verdampfertiegel und mehreren Elektronenkanonen.

(30) Priorität: 20.11.86 DE 3639683

(43) Veröffentlichungstag der Anmeldung:
22.06.88 Patentblatt 88/25

(45) Bekanntmachung des Hinweises auf die Patenterteilung:
01.08.90 Patentblatt 90/31

(84) Benannte Vertragsstaaten:
AT BE CH DE FR GB IT LI NL SE

(56) Entgegenhaltungen:
DE-A- 2 442 032
DE-B- 1 156 521
FR-A- 1 409 439
US-A- 3 526 206
US-A- 3 556 048
US-A- 4 524 717

IBM TECHNICAL DISCLOSURE BULLETIN, Band 26,
Nr. 7B, Dezember 1983, Seite 3847, New York, US; P.D.
HOH: "Grounding shield for electron beam gun"

(73) Patentinhaber: LEYBOLD AKTIENGESELLSCHAFT,
Bonner Strasse 498, D-5000 Köln 51 (DE)

(72) Erfinder: Ranke, Horst, Dr., Brentanostrasse 34,
D-8755 Alzenau(DE)
Erfinder: Bauer, Volker, Ravolzhäuser Strasse 5,
D-6451 Neuberg(DE)
Erfinder: Feuerstein, Albert, Dr., Ringstrasse 12,
D-6451 Neuberg(DE)
Erfinder: Dietrich, Walter, Dr., Reichenberger Strasse 21,
D-6450 Hanau am Main(DE)

(74) Vertreter: Zapfe, Hans, Dipl.-Ing., Am Eichwald 7,
D-6056 Heusenstamm 2 Rembrücken(DE)

## Beschreibung

Die Erfindung betrifft eine Verdampferanordnung für die Beschichtung von in einem Flächenbereich angeordneten oder durch einen Flächenbereich hindurchgeführten Substraten, bestehend aus einem rechteckigen Verdampfertiegel mit einem Tiegelrand und einer längsten Tiegelachse, sowie mit einer Mehrzahl von Elektronenkanonen, die je ein X-Y-Ablenksystem aufweisen und auf einer Seite der Tiegelachse vom Tiegel getrennt angeordnet sind, derart, daß ihre Strahlachsen parallel zueinander verlaufen und auf eine durch die Tiegelachse gehende senkrechte Ebene ausgerichtet sind, wobei die Elektronenstrahlen durch eine weitere Ablenkeinrichtung auf die Oberfläche des Tiegelinhalts ablenkbar sind.

Durch die DE-PS 22 06 995 ist ein Elektronenstrahlverdampfer bekannt, bei dem ein Strahlerzeuger mit einem oder mehreren Verdampfertiegeln zusammenwirkt, deren nach oben gerichtete Öffnungen kreisförmig ausgebildet sind. Der Strahlerzeuger liegt dabei zum Schutze der empfindlichen Katode unterhalb des Tiegelrandes, und der Elektronenstrahl wird mittels eines Magnetfeldes um 180 Grad auf das Verdampfungsgut bzw. in die Tiegelmündung umgelenkt. Das zur Erzeugung des Magnetfeldes benötigte Ablenksystem ist jedoch oberhalb einer Ebene angeordnet, die durch den Tiegelrand verläuft, so daß ein Teil des Dampfes unvermeidbar auf dem Ablenksystem kondensiert. Es ist auch bekannt, den Strahlerzeuger so seitlich und unterhalb des Tiegelrandes anzuordnen, daß der Elektronenstrahl um einen Winkel von 270 Grad abgelenkt werden muß, um durch die Tiegelmündung hindurch auf das Verdampfungsgut aufzutreffen. Es ist schließlich auch bekannt, den Elektronenstrahl der vorstehend beschriebenen Verdampferanordnungen so innerhalb der Tiegelmündung abzulenken, daß das Verdampfungsgut periodisch von dem wandernden Elektronenstrahl getroffen wird (DE-AS 20 47 138).

Allen diesen Verdampferanordnungen ist gemeinsam, daß sie im wesentlichen nur eine quasi-punktförmige Dampfquelle darstellen. Selbst wenn man mehrere dieser Dampfquellen in einer Reihenanordnung anbringen würde, so ergäbe sich dabei immer noch ein stark inhomogener Dampfstrom, der bei der Beschichtung von Folien oder anderen großflächigen Substraten zu einer streifenförmigen Schichtdickenverteilung führen würde.

Durch die DE-PS 28 12 285 ist es bekannt, einem rechteckigen Verdampfertiegel mit einer längsten Tiegelachse zwei Elektronenkanonen mit je einen X-Y-Ablenksystem zuzuordnen, mit denen praktisch die gesamte Oberfläche des Verdampfungsgutes mit einer definierten Energieverteilung pro Flächenelement beaufschlagt werden kann. Dadurch ist es möglich, eine Vielzahl von Substraten, die in einem größeren Flächenbereich angeordnet sind, weitgehend homogen mit Legierungsschichten zu bedampfen. Bei der bekannten Lösung sind jedoch die Elektronenkanonen oberhalb des Verdampfertiegels angeordnet, so daß durch besondere Abschirmeinrichtungen dafür Sorge getragen werden muß, daß die in die Vakuumkammer hineinragenden Teile der Elektronenkanonen nicht in unzulässigem Maße einer Dampfkondensation ausgesetzt werden. Die bekannte Anordnung ist jedoch auf die Verwendung von zwei Elektronenkanonen beschränkt. Wegen der gleichfalls begrenzten Ablenkmöglichkeit der beiden Elektronenstrahlen ist daher auch die maximale Tiegellänge begrenzt. Weiterhin ist den Verdampfertiegeln kein eigenes Magnetfeld zugeordnet, so daß ein großer Teil der Elektronen von der Oberfläche des schmelzflüssigen Verdampfungsguts, d.h. von der Badoberfläche, reflektiert wird. Wie sich weiterhin aus der DE-PS 28 12 311 ergibt, können die reflektierten Elektronen in vorteilhafter Weise zur zusätzlichen Beheizung der Substrate verwendet werden, falls dies dem beschriebenen Beschichtungsprozeß förderlich ist. Da jedoch die Substrate nicht auf beliebig hohe Temperaturen aufgeheizt werden dürfen, ist notwendigerweise auch die Leistung der Elektronenkanonen begrenzt, so daß der Durchsatz an Substraten durch eine solche Vorrichtung gleichfalls begrenzt ist. Für temperaturempfindliche Substrate verbietet sich eine solche Anordnung von vornherein.

Zum Stande der Technik gehört auch eine Verdampferanordnung der eingangs beschriebenen Gattung, bei der mehrere Elektronenstrahlkanonen mit parallel verlaufenden Strahlachsen (definiert durch ihre Strahlführungsrohre) auf je einer Seite eines rechteckigen Verdampfertiegels angeordnet sind und bei der die Strahlachsen in untereinander parallelen senkrechten Ebenen liegen, die ihrerseits wiederum senkrecht zu einer weiteren Ebene verlaufen, die senkrecht durch die längste Tiegelachse hindurchgelegt ist. Hierbei befinden sich die jeder einzelnen Elektronenkanone zugeordneten Ablenksysteme jedoch oberhalb einer durch den Tiegelrand verlaufenden Ebene, so daß die Ablenksysteme und die Mündung der Elektronenkanone vom Dampf, reflektierten Elektronen und von der Wärmestrahlung getroffen werden. Auch bei einer solchen Anordnung ist die insgesamt zuführbare elektrische Leistung begrenzt, zumal auch hierbei das Problem besteht, daß die unvermeidbar reflektierten Elektronen die Substrate und Anlagenbauteile treffen und damit zusätzlich aufheizen. Ein dem Verdampfertiegel unmittelbar zugeordnetes magnetisches Ablenkfeld ist bei dieser bekannten Anordnung gleichfalls nicht vorgesehen.

Es wäre nun theoretisch denkbar, an den Schmalseiten des Verdampfertiegels Polplatten vorzusehen, um im Bereich des Verdampfertiegels ein zusätzliches magnetisches Ablenkfeld vorzusehen, durch das die Elektronenstrahlen auf das Verdampfungsgut abgelenkt werden. Eine solche Möglichkeit scheitert jedoch an dem weitgehend bogenförmigen bzw. tonnenförmigen Verlauf der Feldlinien, der zu erheblichen Inhomogenitäten in der Strahlablenkung führen würde . Man war daher gezwungen, eine solche Verdampferanordnung in Längsrichtung in mehrere einzelne Tiegel zu unterteilen und Polplatten bis in die Zwischenräume der einzelnen Tiegel hineinzuführen, um eine zuverlässige Strahlablenkung herbeiführen zu können. Eine solche Anordnung ist in der DE-AS 28 15 627 beschrieben. Sie führt jedoch wiederum zu dem Nachteil einer Reihenanordnung nahezu punktförmiger Verdampfungsquellen.

Der Erfindung liegt daher die Aufgabe zugrunde, eine Verdampferanordnung der eingangs beschriebenen Gattung dahingehend zu verbessern, daß in Bezug auf eine praktisch unbegrenzte Zahl von Elektronenstrahlen über die gesamte Länge des Verdampfertiegels weitgehend identische magnetische Ablenkfelder für jeden einzelnen Elektronenstrahl erzeugt werden können, soweit dies den Strahlverlauf oberhalb des rechteckigen Verdampfertiegels betrifft.

Die Lösung der gestellten Aufgabe erfolgt bei der eingangs angegebenen Verdampferanordnung erfindungsgemäß dadurch, daß auf der den Elektronenkanonen gegenüberliegenden Seite des Tiegels eine abwechselnde Reihenanordnung von Linearspulen und dazwischen sowie an deren Enden befindliche Polplatten angeordnet ist, wobei jeweils zwei an den Enden einer Linearspule liegende Polplatten eine solche Lage zu jeweils einer gegenüberliegenden Elektronenkanone haben, daß die Strahlachse sich im wesentlichen in einer zwischen den besagten Polplatten liegenden senkrechten Symmetrieebene befindet.

Die Polplatten liegen dabei außerhalb der rechteckigen Umrißlinie des Tiegels, so daß das Tiegelvolumen durch die Polplatten nicht unterteilt wird und insbesondere auch nicht eine Unterteilung in einzelne Verdampfertiegel stattfindet. Die aus den erfindungsgemäß angeordneten Polplatten austretenden magnetischen Feldlinien haben zwar gleichfalls einen bogenförmigen bzw. tonnenförmigen Verlauf, jedoch ist der mit dem jeweiligen Elektronenstrahl zusammenwirkende Ausschnitt aus einem jeden Magnetfeld als hinreichend linear anzusehen und insbesondere im Hinblick auf jeden einzelnen Elektronenstrahl weitgehend identisch. Es kann daher einem verhältnismäßig langen rechteckigen Verdampfertiegel eine verhältnismäßig große Anzahl von Elektronenkanonen zugeordnet werden, ohne daß sich die Verdampfungscharakteristik über die Länge des gesamten Verdampfertiegels unzulässigerweise ändert.

Der Erfindungsgegenstand besitzt jedoch noch eine Reihe weiterer Vorteile: Die Verdampferanordnung läßt sich außerordentlich flach ausführen, so daß der Abstand zwischen dem Substrat oder den Substraten und dem oberen Tiegelrand klein gehalten werden kann, wodurch die Materialausbeute bzw. der Materialwirkungsgrad beträchtlich verbessert wird.

Die gesamte Längenausdehnung der Verdampferanordnung kann praktisch beliebig vergrößert werden. Dies ist von besonderem Vorteil, wenn breite Bänder oder Platten während eines kontinuierlichen Durchlaufs durch den Bereich über dem Verdampfertiegel beschichtet werden sollen.

Durch die erfindungsgemäße Anordnung entsteht eine Reihenanordnung von wiederkehrenden Magnetfeldern gleicher Konfiguration, die außer einer definierten Strahlablenkung auch reflektierte Elektronen bzw. Streuelektronen auf das Verdampfungsgut zurückführt, so daß die erforderliche elektrische Leistung reduziert werden kann. Dadurch wird aber nicht nur die effektiv in das Verdampfungsgut eingebrachte Leistung verbessert, sondern es erfolgt auch eine Reduzierung der thermischen Substratbelastung durch reflektierte Elektronen.

Die erfindungsgemäße Verdampferanordnung gestattet die Verdampfung von Materialien bei praktisch senkrechtem Auftreffen des Elektronenstrahls auf das Verdampfungsgut. Dadurch wird ein symmetrischer Verdampfungskegel erzeugt. Unter "Verdampfungskegel" versteht man ein im Vakuum sinngemäß abgegrenztes Volumen, das von der Hauptmenge des verdampften Materials durchströmt wird. Sofern der Elektronenstrahl senkrecht auf das Verdampfungsgut auftrifft, verläuft auch die Achse des genannten Verdampfungskegels senkrecht zur Oberfläche des Verdampfungsguts, und die besagte Kegelachse geht von demjenigen Punkt aus, in dem der Elektronenstrahl auf die Oberfläche des Verdampfungsgutes auftrifft.

Es ist dabei auch keineswegs erforderlich, daß der Auftreffpunkt des Elektronenstrahls, der sogenannte Brennfleck, stationär gehalten wird, sondern es ist vielmehr mit besonderem Vorteil möglich, den genannten Brennfleck innerhalb eines dem jeweiligen Elektronenstrahl zugeordneten Bereichs nach einem bestimmten Flächenmuster abzulenken, wie dies beispielhaft in der DE-PS 28 12 285 beschrieben ist. Ein solcher Bereich liegt dabei vorzugsweise zwischen der Verlängerung derjenigen Polplatten, die einem Elektronenstrahl bzw. einer Elektronenkanone zugeordnet sind. Es ist aber ohne weiteres möglich, daß sich diese Bereiche auch überlappen.

Es ist dabei besonders vorteilhaft, wenn die Polplatten und/oder die Elektronenkanonen vollständig unterhalb einer horizontalen Ebene angeordnet sind, die durch den Tiegelrand verläuft. In dieser Weise sind die Polplatten und/oder die Elektronenkanonen vollständig gegen ein Bedampfen bzw. eine Kondensation von Verdampfungsgut und gegen eine thermische Belastung durch Elektronen sowie durch Wärmestrahlung geschützt.

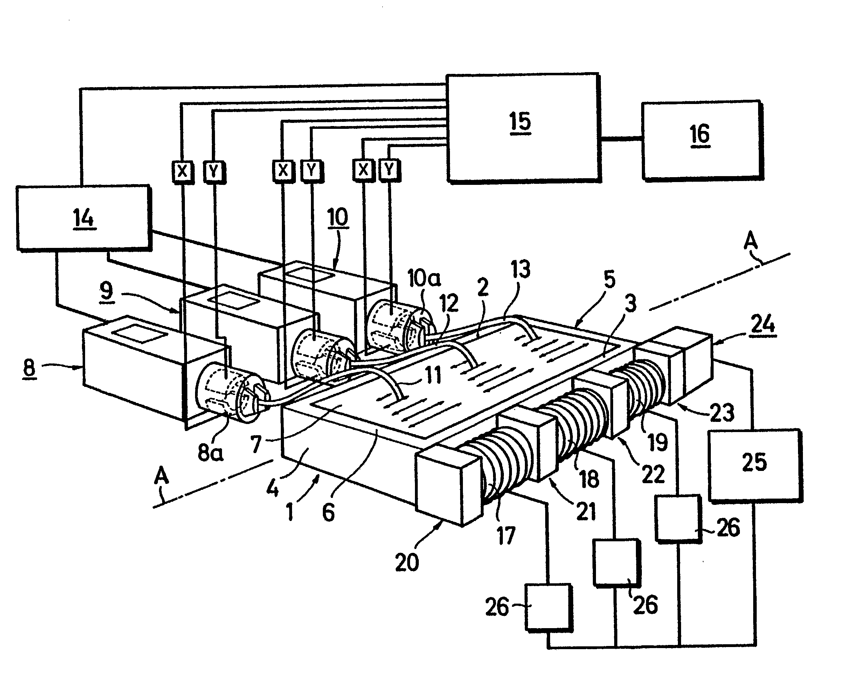

Ein Ausführungsbeispiel des Erfindungsgegenstandes wird in Verbindung mit einem Blockschaltbild anhand der einzigen Figur näher erläutert, die im wesentlichen aus einer perspektivischen Darstellung besteht.

In der Figur ist ein rechteckiger Verdampfertiegel 1 mit zwei Langseiten 2 und 3 und zwei Schmalseiten 4 und 5 sowie einem oberen Tiegelrand 6 dargestellt, der in einer horizontalen Ebene liegt. In dem Verdampfertiegel 1 befindet sich das Verdampfungsgut 7, dessen Beschaffenheit und/oder Zusammensetzung sich nach dem Endzweck des beschichteten Substrats richtet, das in der Figur jedoch nicht dargestellt ist. Man hat sich das Substrat oder die Substrate in einer Ebene vorzustellen, die knapp über dem Tiegelrand 6 und parallel zu diesem verläuft. Durch den Tiegelrand 6 wird eine Tiegelöffnung definiert, die ihrerseits wieder einen Flächenbereich beschreibt, in dem stationäre oder stationär bewegliche Substrate angeordnet sein können oder durch den sie hindurchgeführt werden können, wie beispielsweise eine zu beschichtende Folie oder am laufenden Band zu beschichtenden Platten.

Der Verdampfertiegel 1 besitzt eine längste Tiegelachse A-A, von der in der Figur nur die beiden Enden angedeutet sind. Diese Tiegelachse A-A verläuft parallel zu den Langseiten 2 und 3, senkrecht zu den Schmalseiten 4 und 5 und durch den Tiegelrand 6 hindurch. Es handelt sich um eine ideele Achse, die nur dazu dient, die geometrischen Verhältnisse zu definieren.

Hinter der Langseite 2 befindet sich eine Reihenanordnung von Elektronenkanonen 8, 9 und 10, von denen hier nur die Gehäuse sowie Gehäusefortsätze 8a, 9a und 10a dargestellt sind, in denen sich Ablenkeinheiten herkömmlicher Beschaffenheit befinden, wie sie beispielhaft auch in der DE-PS 28 12 285 und in der DE-PS 28 12 311 beschrieben sind. Jede dieser Elektronenkanonen sendet einen Elektronenstrahl 11, 12 und 13 aus, der zunächst aufgrund der in den Gehäusefortsätzen 8a bis 10a vorhandenen Ablenksysteme schwach aufwärts gerichtet ist, um über den Tiegelrand 6 zu gelangen.

Es versteht sich, daß die Elektronenkanonen 8, 9 und 10 einschließlich ihrer Gehäuse unterhalb einer horizontalen Ebene angeordnet sind, in der auch der Tiegelrand 6 liegt.

Die Elektronenkanonen 8, 9 und 10 werden hinsichtlich ihrer Strahldaten von einer Regelanordnung 14 gesteuert, die im wesentlichen eine Leistungsregelung bewirkt. Die Regelanordnung 14 erhält ihre Regelsignale wiederum über einen Mikroprozessor 15, in dem die erforderlichen Daten durch eine Dateneingabevorrichtung 16 eingebbar sind. Von dem Mikroprozessor 15 führen Steuerleitungen zu jeweils mit "X" und "Y" bezeichneten Verstärkern, die ihrerseits die Ablenkströme für die in den Gehäusefortsätzen 8a, 9a und 10a untergebrachten Ablenksysteme liefern. Mittels der Ablenkströme sind die Elektronenstrahlen 11, 12 und 13 zunächst in Richtung eines X-Y-Koordinatensystems ablenkbar, das man sich senkrecht zwischen den Elektronenkanonen 8, 9 und 10 und dem Verdampfertiegel 1 aufgestellt denken kann. Innerhalb der Elektronenkanonen 8 und 9 verläuft der Elektronenstrahl (ausgehend von einer Katode) im wesentlichen geradlinig und gleichfalls horizontal innerhalb eines sooenannten Strahlführungsrohres, das, für sich genommen, gleichfalls zum Stande der Technik gehört. Dadurch verlaufen die Elektronenstrahlen zumindest am Anfang ihrer Gestehungsgeschichte parallel zueinander und sind auf eine durch die Tiegelachse A-A gehende senkrechte Ebene ausgerichtet. In ihrem weiteren Verlauf (außerhalb der Elektronenkanonen 8, 9 und 10) müssen die Elektronenstrahlen auf die Oberfläche des Verdampfungsgutes 7, den sogenannten "Badspiegel" umgelenkt werden, wie dies in der Figur dargestellt ist.

Zu diesem Zweck ist auf der den Elektronenkanonen gegenüberliegenden Seite des Verdampfertiegels 1 eine abwechselnde Reihenanordnung von Linearspulen 17, 18 und 19 angeordnet. Zwischen diesen Linearspulen und an deren Enden befinden sich Polplatten 20, 21, 22 und 23, die senkrecht auf die Tiegelachse A-A ausgerichtet sind, jedoch in Richtung auf den Tiegel unmittelbar vor dessen Langseite 3 enden. Auch die Oberkanten der Polplatten 20 bis 23 sind in oder unterhalb einer waagrechten Ebene angeordnet, in der auch der Tiegelrand 6 verläuft. Die Anordnung ist dabei so getroffen, daß jeweils zwei an den Enden einer Linearspule (z.B. 17) liegende Polplatten (z.B. 20 und 21) eine solche Lage zu einer jeweils gegenüberliegenden Elektronenkanone (z.B. 8) haben, daß die Strahlachse sich (in einer mittleren Stellung des Elektronenstrahls) im wesentlichen in einer zwischen den besagten Polplatten liegenden senkrechten Symmetrieebene befindet. Diese Symmetrieebene verläuft senkrecht zu der Tiegelachse A-A. Wie bereits weiter oben beschrieben wurde, läßt sich der Elektronenstrahl natürlich ausgehend von dieser mittleren Stellung nach einem vorgegebenen Ablenkmuster ablenken.

Der rechts außen liegenden Polplatte 23 ist ein Magnetfeldsensor 24 zugeordnet, der über ein Steuergerät 25 mehrere Verstärker 26 ansteuert, durch die ein definierter Ablenkstrom in den einzelnen Linearspulen 17, 18 und 19 erzeugt wird.

Durch die Polplatten 20 bis 23 wird in Verbindung mit den Linearspulen 17 bis i9 zwischen zwei jeweils unmittelbar benachbarten Polplatten (20/21; 21/22; 22/23) jeweils ein Ablenkmagnetfeld erzeugt, von dem wesentliche Teile bis in den Bereich oberhalb des Verdampfungsgutes 7 hineinreichen. Diese Felder, die auch als Streufelder bezeichnet werden können, sind durch die parallel zur Tiegelachse A-A verlaufenden Doppelpfeile angedeutet. Die betreffenden Feldlinien verlaufen in ihrem mit den Elektronenstrahlen 11, 12 und 13 in Wechselwirkung tretenden Bereich in ausreichendem Maße linear und parallel zu der genannten Tiegelachse A-A, wie dies gleichfalls durch die besagten Doppelpfeile angedeutet ist.

Durch die im vorliegenden Falle drei Magnetfelder, deren Feldlinien im wesentlichen senkrecht zum Strahlweg der Elektronenstrahlen 11, 12 und 13 verlaufen, werden diese Elektronenstrahlen - wie aus der Figur ersichtlich - auf bogenförmigen Bahnen abgelenkt und auf die Oberfläche des Verdampfungsguts 7, dem sogenannten Badspiegel gerichtet. Auch dienen die genannten magnetischen Felder (Streufelder) dazu, die an der Auf treffstelle (Brennfleck) des jeweiligen Elektronenstrahls erzeugten Sekundär-Elektronen gleichfalls wieder in Richtung auf den Badspiegel zu beschleunigen, so daß auch diese Sekundär-Elektronen zusätzlich zur Badbeheizung beitragen, nicht aber zu einer unerwünschten Aufheizung des darüber befindlichen Substrats.

**Patentansprüche**

1. Verdampferanordnung für die Beschichtung von in einem Flächenbereich angeordneten oder durch einen Flächenbereich hindurchgeführten Substraten, bestehend aus einem rechteckigen Verdampfertiegel mit einem Tiegelrand und einer längsten Tiegelachse, sowie mit einer Mehrzahl von Elektronenkanonen, die je ein X-Y-Ablenksystem aufweisen und auf einer Seite der Tiegelachse vom Tiegel getrennt derart angeordnet sind, daß ihre Strahlachsen parallel zueinander verlaufen und auf eine durch die Tiegelachse gehende senkrechte Ebene ausgerichtet sind, wobei die Elektronenstrahlen durch eine weitere Ablenkeinrichtung auf die Oberfläche des Tiegelinhalts ablenkbar sind, dadurch gekennzeichnet, daß auf der den Elektronenkanonen (8, 9, 10) gegenüberliegenden Seite des Tiegels (1) eine abwechselnde Reihenanordnung von Linearspulen (17, 18, 19) und dazwischen sowie an deren Enden befindlichen Polplatten (20, 21, 22, 23) angeordnet sind, wobei jeweils zwei an den Enden einer Linearspule (17) liegende Polplatten (20, 21) eine solche Lage zu einer jeweils gegenüberliegenden Elektronenkanone (8) haben, daß die Strahlachse sich im wesentlichen in einer zwischen den besagten Polplatten liegende senkrechten Symmetrieebene befindet.

2. Verdampferanordnung nach Anspruch 1, dadurch gekennzeichnet, daß die Polplatten (20, 21, 22, 23) vollständig unterhalb einer horizontalen, durch den Tiegelrand (6) gehenden Ebene angeordnet sind.

3. Verdampferanordnung nach Anspruch 1, dadurch gekennzeichnet, daß die Elektronenkanonen (8, 9, 10) vollständig unterhalb einer horizontalen, durch den Tiegelrand (6) gehenden Ebene angeordnet sind.

## Claims

1. Vaporizer arrangement for coating substrates disposed in a surface area or conveyed through a surface area, comprising a rectangular vaporizer crucible having a crucible edge and a longest crucible axis, as well as having a plurality of electron guns which each have an X–Y deflection system and are disposed on one side of the crucible axis separately from the crucible in such a manner that their beam axes extend parallel to one another and are oriented towards a vertical plane passing through the crucible axis, the electron beams being deflectable towards the surface of the crucible contents by means of a further deflection device, characterised in that on the opposite side of the crucible (1) to the electron guns (8, 9, 10) there is an alternating row of linear coils (17, 18, 19) and pole plates (20, 21, 22, 23), said plates being located between and at either end of the coils, with each two pole plates (20, 21) located at the ends of a linear coil (17) being positioned in such a way relative to an opposing electron gun (8) that the beam axis is located substantially in a vertical plane of symmetry lying between said pole plates.

2. Vaporizer arrangement according to claim 1) characterised in that the pole plates (20, 21, 22, 23) are disposed completely below a horizontal plane passing through the crucible edge (6).

3. Vaporizer arrangement according to claim 1, characterised in that the electron guns (8, 9, 10) are disposed completely below a horizontal plane passing through the crucible edge (6).

## Revendications

1. Installation de vaporisation pour le revêtement de substrats qui sont disposés dans une zone de surface ou que l'on fait passer à travers une zone de surface, constituée d'un creuset rectangulaire de vaporisation avec un bord du creuset et un axe le plus long du creuset, ainsi qu'avec une pluralité de canons à électrons qui présentent chacun un système de déviation X-Y et sont disposés, séparément, d'un côté de l'axe du creuset de façon telle que les axes de leur faisceau soient dirigés parallèlement l'un à l'autre et sur un plan vertical passant par l'axe du creuset, étant précisé que les faisceaux d'électrons peuvent être déviés, par un autre dispositif de déviation, sur la surface du contenu du creuset, caractérisée en ce que du côté du creuset (1) opposé aux canons à électrons (8, 9, 10) est disposée une rangée comprenant alternativement des bobines linéaires (17, 18, 19) et des plaques polaires (20, 21, 22, 23) qui se trouvent entre ces bobines ainsi qu'à leurs extrémités, étant précisé que deux plaques polaires (20, 21) qui se trouvent respectivement aux extrémités d'une bobine linéaire (17) ont, par rapport à un canon à électrons (8) situé respectivement en face, une position telle que l'axe du faisceau se trouve sensiblement dans un plan de symétrie vertical situé entre lesdites plaques polaires.

2. Installation de vaporisation selon la revendication 1, caractérisée en ce que les plaques polaires (20, 21, 22, 23) sont entièrement disposées en dessous d'un plan horizontal passant par le bord (6) du creuset.

3. Installation de vaporisation selon la revendication 1, caractérisée en ce que les canons à électrons (8, 9, 10) sont entièrement disposés en dessous d'un plan horizontal passant par le bord (6) du creuset.